# EUROPÄISCHE PATENTSCHRIFT

(11) **EP 1 277 243 B1**
(45) Veröffentlichungstag und Bekanntmachung des Hinweises auf die Patenterteilung: **04.01.2012**
(21) Anmeldenummer: 00958371.7
(22) Anmeldetag: 03.08.2000
(51) Int. Cl.: H01L 41/083, H01L 41/047, G01F 23/296, G01P 15/09

(54) **PIEZOKERAMISCHER MEHRSCHICHTBAUTEIL FÜR MESSGERÄTE SOWIE DESSEN HERSTELLUNGSVERFAHREN**
PIEZO-CERAMIC MULTILAYER COMPONENT FOR MEASURING INSTRUMENTS AND METHOD FOR THE PRODUCTION THEREOF
COMPOSANT MULTICOUCHE PIEZO-CERAMIQUE POUR APPAREILS DE MESURE ET SON PROCEDE DE PRODUCTION

(30) Priorität: 27.04.2000 DE 10020549
(43) Veröffentlichungstag der Anmeldung: 22.01.2003
(73) Patentinhaber: Endress + Hauser GmbH + Co. KG, 79689 Maulburg (DE)
(72) Erfinder: LOPATIN, Sergej, 79540 Lörrach (DE); GETMAN, Igor, 79539 Lörrach (DE); PANITCH, Anatoliy, Rostow-on-Don, 34401 (RU); WUSEWKER, Yuriy, Tostow-on-Don, 344102 (RU)
(74) Vertreter: Andres, Angelika Maria
(86) Internationale Anmeldenummer: PCT/EP2000/007506
(87) Internationale Veröffentlichungsnummer: WO 2001/084642

(56) Entgegenhaltungen:
- EP-A- 0 826 643
- DE-C- 3 931 453
- US-A- 4 816 713
- US-A- 4 918 350
- US-A- 5 168 189
- US-A- 5 300 852
- PATENT ABSTRACTS OF JAPAN vol. 009, no. 255 (E-349), 12. Oktober 1985 (1985-10-12) & JP 60 103685 A (NIPPON SOKEN INC), 7. Juni 1985 (1985-06-07)

## Beschreibung

Die Erfindung betrifft einen elektromechanischen Antrieb bzw. ein Sensorelement für ein Meßgeräte sowie ein Verfahren zu deren Herstellung. Sie betrifft insbesondere in Stapelbauweise aus piezo-elektrischen Elementen gefertigte Antriebe und Sensorelemente und die damit ausgerüsteten Meßgeräte.

Bekannte Meßgeräte dieser Art sind z.B. piezo-elektrische Beschleunigungssensoren und Füllstandsmeßgeräte. Diese Meßgeräte umfassen meist einen Grundkörper, auf dem der Antrieb bzw. das Sensorelement angebracht ist, wobei diese piezo-elektrische Elemente, Elektroden und elektrischen Verbinder und Anschlüsse enthalten. Die piezo-elektrischen Elemente sind elektrisch miteinander verbunden und an eine dem Anwendungsfall entsprechende Elektronikschaltung angeschlossen.

Derartige piezo-elektrische Meßgeräte zeigen eine relativ große Ladungsempfindlichkeit und eine relativ geringe transversale Empfindlichkeit. Ihr besonderer Nachteil ist jedoch ihr relativ begrenzter, effektiver Arbeitsbereich bei hohen Temperaturen ab z.B. 200°C, unter Einwirkung hoher statischer Drücke bis z.B. 500 bar oder, im Falle der Beschleunigungssensoren, bei hohen dynamischen Belastungen, bei denen Beschleunigungen bis zu 2000g auftreten.

Die Empfindlichkeit der piezo-elektrischen Meßgeräte gegenüber den geschilderten Belastungen ist durch den Aufbau ihres Antriebs bzw. Sensorelements bedingt. Üblicherweise ist ein solcher Antrieb bzw. ein solches Sensorelement aus aufeinander folgenden und geometrisch aufeinander abgestimmten piezo-elektrischen Anschlüssen aufgebaut. Es werden also verschiedenen Materialien, wie z.B. Piezokeramik und Metall, miteinander kombiniert, die sich in ihren Elastizitätsmodulen und ihren jeweiligen Wärmeausdehnungskoeffizienten unterscheiden. Unter dem Einfluß der erwähnten hohen Temperaturen und/oder großen statischen und dynamischen Belastungen des Sensorelements bzw. des Antriebs entstehen in den piezo-elektrischen Elementen selbst ausgedehnte mechanische planare Spannungen, die nicht nur die Festigkeit des Sensorelements sondern auch das Nutz- bzw. Meßsignal mindern. Bei bekannten Meßgeräten der beschriebenen Art hat sich außerdem ein in Schichtbauweise aufgebauter monolithischer Dünnschichtkondensator als vorteilhaft erwiesen, der auch, wie z.B. bei Füllstandsmeßgeräten, als Mehrfach-Kondensator aus dünnen Schichten aufgebaut sein kann. Hierbei umfaßt die Schichtfolge des Monoliths die piezo-elektrischen Dünnschichten und Elektroden, wobei längs des Monoliths angeordnete elektrische Verbinder vorgesehen sind. Üblicherweise verbindet dann ein Verbinder (vielfach auch als "Schiene" bezeichnet) die Elektroden des einen Pols und ein anderer Verbinder die des anderen Pols. Ein derartiger monolithischer Aufbau besitzt eine große Stabilität und Festigkeit und gestattet, Vibrationsparameter durch die Senkung des relativen Koeffizienten der transversalen Transformation recht genau zu messen.

Aus der Druckschrift US 5,618,189-A, den Patent Abstracts of Japan vol 009, No. 255 (E-34) vom 12.10.1985 und der Druckschrift JP 60 103685 A sind elektromagnetische Antriebe in Schichtbauweise bekannt, bei denen jeweils zwischen zwei benachbarte piezo-elektrische Keramikschichten eine plattenförmige Elektrode verpresst wird. Die plattenförmige Elektroden bilden zusammen mit sie verbindenenden Stegen ein durchgehendes metallisches Band, das jeweils um die Keramikschichten herumgebogen wird.

Der Aufbau der piezo-elektrischen Antriebe nach der Druckschrift US 5,618,189-A, den Patent Abstracts of Japan vol 009, No. 255 (E-34) vom 12.10.1985 und der Druckschrift JP 60 103685 A basiert jedoch auf einer asymmetrischen Form der Elektroden bzw. Keramikscheiben, die auf der einen Seite einen vorspringenden Teil für die Verbindung mit einer Schiene und auf der gegenüberliegenden Seite ein isolierendes Spiel zur anderen Schiene hat. Inhomogenitäten im strukturellen Aufbau solcher Antriebe bzw. Sensorelemente wirken sich jedoch negativ auf die Größe des relativen Koeffizienten der transversalen Transformation aus. Außerdem erlaubt die asymmetrischen Form der Elektroden nicht, die gesamte Elektrodenffäche der piezo-elektrischen Schichten aufzuladen, wie es zur Vergrößerung des Koeffizienten der transversalen Transformation wünschenswert wäre. Je geringer die Metallisierungsfläche des betrachteten piezo-elektrischen Schicht im Verhältnis zu ihrer eigentlichen Nutzfläche ist, desto mehr verringert sich der Koeffizienten der Transformation.

Ein weiterer piezo-elektrischer Antrieb in Schichtbauweise wird in der Druckschrift US 5,300,852-A beschrieben. Hierbei sind jeweils zwischen zwei benachbarten piezo-elektrischen Keramikschichten eine plattenförmige Elektrode angeordnet wird. Zur elektrischen Verbindung zweier Elektroden ist jeweils außen am Antrieb eine Lötstelle vorgesehen, an die jeweils auf der Außenseite des Antriebs geführte elektrische Verbindungsdrähte angelötet werden. Dieser Antrieb ist aufwendig zu fertigen.

Der Erfindung liegt daher die Aufgabe zugrunde, piezo-elektrische Antriebe bzw. Sensorelemente und ein Verfahren zu deren Herstellung anzugeben, die es bei damit ausgerüstete Meßgeräte erlauben, die oben geschilderten Nachteile vermeiden und die sich auch unter dem Einfluß hoher Temperaturen bzw. hoher statischer und dynamischer Belastungen durch eine große Meßgenauigkeit auszeichnen.

Diese Aufgabe wird nach der Erfindung gelöst durch einen elektromechanischen Antrieb bzw. ein Sensorelement in Schichtbauweise, der bzw. das
- mehrere piezo-elektrische Keramikschichten,
- eine zwischen zwei einander zugewandten Oberflächen von direkt benachbarten piezo-elektrischen Keramikschichten angeordnete Elektrodenschicht und
- einen elektrischen Verbinder zur elektrischen Kontaktierung der Elektrodenschicht umfaßt,
- wobei der Verbinder ebenfalls zwischen den zwei einander zugewandten Oberflächen der piezo-elektrischen Keramikschichten angeordnet und herausgeführt ist,
- wobei der Verbinder ein sich über die Oberflächen der piezo-elektrischen Keramikschichten hinaus erstreckender Draht ist,
- und wobei in mindestens einer der zwei einander zugewandten Oberflächen der piezo-elektrischen Keramikschichten eine Nut vorgesehen ist, die den elektrischen Verbinder wenigstens teilweise aufnimmt.

Bei einer bevorzugten Ausführungsform der Erfindung wird die Elektrodenschicht durch Metallbeschichtung metallisierte und mittels Diffusionsschweißen zusammengefügte Oberflächen der piezo-elektrischen Keramikschichten gebildet.

Bei einer anderen bevorzugten Ausführungsform der Erfindung ist der Verbinder ein sich über die Oberflächen der piezo-elektrischen Keramikschichten hinaus erstreckender Draht.

Bei noch einer anderen bevorzugten Ausführungsform des Antriebs bzw. Sensorelements nach der Erfindung sind wenigstens drei piezo-elektrischen Keramikschichten und wenigstens zwei Nuten vorgesehen, wobei diese Nuten zueinander und in Bezug auf eine Längsachse des Antriebs bzw. Sensorelements versetzt angeordnet sind.

In einer Weiterbildung einer bevorzugten Ausführungsform der Erfindung hat der Draht eine wellige oder gezackte Struktur.

In einer Weiterbildung einer bevorzugten Ausführungsform der Erfindung hat der Draht eine wellige oder gezackte Struktur.

In anderen Weiterbildungen der Erfindung bestehen die piezo-elektrischen Keramikschichten aus PZT-Material, wie z.B. aus PbMg_{0,308}Nb_{0,617}Ti_{0,075}O₃, oder aus Keramikschichten aus einem Material mit einer Curie-Temperatur größer 400°C besteht, beispielsweise aus Na_{0,5}Bi_{4,5}Ti₄O₁₅ bzw. Bi₃TiNbO₉.

Bei anderen Weiterbildungen der Erfindung bestehen die Elektrodenschichten aus einem metallischen Material mit einer Curie-Temperatur größer 400°C, wie z.B. aus Wismut-Titanat.

Noch andere Weiterbildungen der Erfindung betreffen Drähte aus einem metallischen Material mit einer Hochtemperaturstabilität größer 250°C und solche aus einem silberhaltigen, edelstahlhaltigen Material oder einem Material, das eine Nickellegierung enthält.

Die erwähnte, der Erfindung zugrunde liegende Aufgabe wird darüber hinaus durch einen elektromechanischen Antrieb bzw. ein Sensorelement in Schichtbauweise gelöst, das nach einem Verfahren, welches folgende Schritte umfaßt, hergestellt wird:
- Herstellen von keramischer Schichten aus elektroaktiven Material nach
   einem in der Keramiktechnologie üblichen Verfahren mit gewünschten
   Abmessungen und mit einer Reserve von 2-3 mm für jedes Maß unter
   Berücksichtigung der nachfolgenden mechanischen Bearbeitung;
- Schleifen der keramischen Schichten bis eine vorgegebene Stärke von betrachteten Keramikschicht sein darf;
- Metallbeschichten wenigstens dieser Seite der Keramikschichten durch zweimaliges Aufbringen einer silberhaltigen Paste und nachfolgendes Tempern bei einer Temperatur von 800-820°C;
- Leimen der metallisierten Oberflächen von zwei Keramikschichten mit einem Zelluloseleim;
- Diffusionsschweißen der geleimten Schichten durch Tempern auf eine Temperatur von 780-800°C und einachsiger Kompression unter einem Druck von 3-5 kg/cm² im Verlauf von 3 Stunden und Abkühlung bis auf Zimmertemperatur;
- Einziehen je eines Verbinder-Drahtes in eine Nut;
- Einwirkung eines elektrischen Feldes auf die Drähte unter Hochtemperatur und Einrichten der gewünschten Polarität der Elektrodenschichten durch Verbinden gleicher Pole des Antriebs bzw. des Sensorelements;
- Kontrolle der gewünschten Parameter und piezo-elektrischen Eigenschaften des Antriebs bzw. des Sensorelements .

Es wird weiterhin ein Füllstandsgrenzschalter geschaffen, der mit einem Antrieb und einem Sensorelement nach der Erfindung ausgerüstet ist, wobei in einer Weiterbildung eines solchen Füllstandsgrenzschalters das Sensorelement vom Antrieb durch eine nicht-polarisierte Keramikschicht getrennt wird.

Außerdem wird ein Beschleunigungssensor mit einem Sensorelement nach der Erfindung geschaffen.

Der besondere Vorteil ist, daß es durch den erfindungsgemäßen Aufbau und das erfindungsgemäße Herstellungsverfahren gelingt, einen piezo-elektrischen Antrieb bzw. ein Sensorelement zu schaffen, bei dem der Koeffizient der Ladungstransformation und die Meßgenauigkeit beim Sensorelement dadurch verbessert werden, daß der relative Koeffizient der transversalen Transformation in einem großen Temperaturbereich und bei hohen statischen und dynamischen Belastungen verringert wird.

Die Erfindung wird nachfolgend anhand mehrere Ausführungsbeispiele und unter Bezug auf eine Zeichnung ausführlich erläutert und beschrieben. Dabei zeigen:
- Fig. 1: eine perspektivische Darstellung eines mehrschichtigen bisher bekannten piezo-elektrischen Antriebs bzw. Sensorelements;
- Fig. 2: eine perspektivische Darstellung einer ersten Ausführungsform eines mehrschichtigen piezo-elektrischen Antriebs bzw. Sensorelements nach der Erfindung;
- Fig. 3: eine schematische Seitenansicht einer erweiterten Antriebs bzw. Sensorelements nach Fig. 2;
- Fig. 4: eine schematische Darstellung mehrerer Schichten einer zweiten Ausführungsform eines piezo-elektrischen Antriebs bzw. Sensorelements nach der Erfindung;
- Fig. 5: schematische Seitenansichten zweier besonders geformter Drähte für einen Antrieb bzw, ein Sensorelement nach der Erfindung;
- Fig. 6: eine Schnittdarstellung eines Beschleunigungssensors mit einem mehrschichtigen piezo-elektrischen Sensorelements nach der Erfindung; und
- Fig. 7: eine schematische, teilweise aufgeschnittene Darstellung eines Füllstandsgrenzschalters mit einem piezo-elektrischen Antrieb und einem piezo-elektrischen Sensorelement nach der Erfindung.

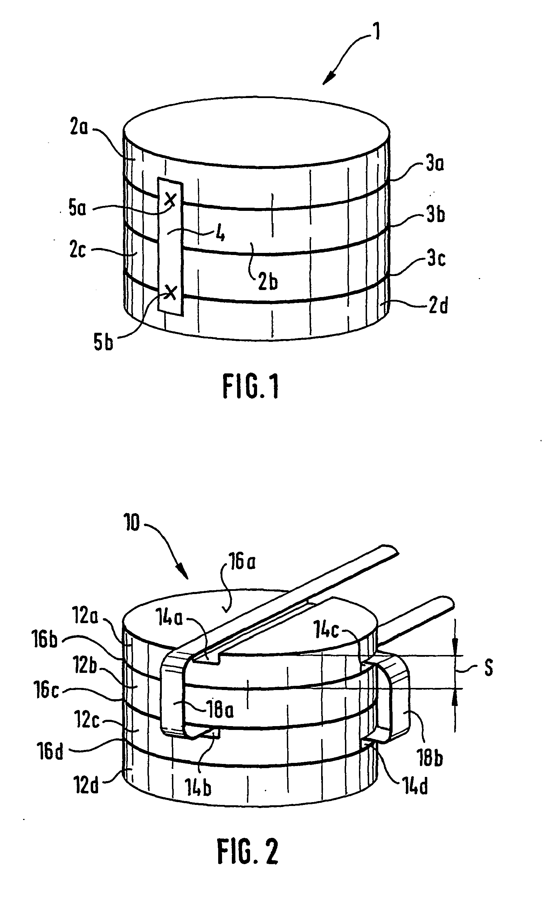

Um die wesentliche Unterschiede der Erfindung zum Stand der Technik aufzeigen zu können, ist in Fig. 1 ein bisher bekannter piezo-elektrischer Antrieb bzw. ein bisher bekanntes piezo-elektrisches Sensorelement 1 dargestellt. Dieses wird nachfolgend und der Einfachheit halber als piezo-elektrisches Element 1 bezeichnet. Es besteht im wesentlichen aus piezo-keramischen Scheiben 2a, b, c, d, bei denen wenigstens eine der zueinander zugewandten Oberflächen elektrischer Antrieb bzw. ein bisher bekanntes piezo-elektrisches Sensorelement 1 dargestellt. Dieses wird nachfolgend und der Einfachheit halber als piezo-elektrisches Element 1 bezeichnet. Es besteht im wesentlichen aus piezo-keramischen Scheiben 2a, b, c, d, bei denen wenigstens eine der zueinander zugewandten Oberflächen metallisiert und die so, unter Zwischenfügen von Elektroden 3a, b, c aufeinander angeordnet und miteinander auf übliche Weise und so zusammengefügt sind, daß ein Aufbau eines monolithischen Schichtkondensators erreicht wird. In Fig. 1 ist auch ein außen auf der Mantelfläche des piezo-elektrischen Elements 1 angebrachter, metallischer streifenförmiger Verbinder 4 dargestellt, der die Elektroden 3a und 3c in zwei Verbindungspunkten 5a und 5b elektrisch miteinander verbindet. Ein anderer Verbinder von gleichem Typ ist üblicherweise auf der anderen Seite der Mantelfläche des piezo-elektrischen Elements 1 angebracht, der wiederum mit der Elektrode 3b elektrisch verbunden, aber wegen der gewählten Art der Darstellung in Fig. 1 nicht zu sehen ist. An beiden Verbindern können üblicherweise hier nicht dargestellte, elektrische Verbindungsleiter zu einer ebenfalls hier der Einfachheit halber nicht dargestellten Antriebs- bzw. Auswerteelektronik angeschlossen werden.

Um zu verhindern, daß der streifenförmige Verbinder 4 einen unerwünschten Kontakt zur Elektrode 3b herstellt, muß sie an der Stelle, wo der Verbinder 4 vorgesehen ist, ausgespart werden und quasi in das Innere des piezo-elektrischen Elements 1 zurückspringen. Sie kann also nicht die gesamte zur Verfügung stehende Fläche der Scheibe 2b (oder 2c) bedecken, was, wie eingangs erwähnt, den Transformationskoeffizienten an dieser Stelle des piezo-elektrischen Elements 1 negativ beeinflußt. Das Gleiche gilt für den hier nicht sichtbaren Verbinder und die Elektrode 3a. Auch sie muß einen gebührenden Anstand zum Verbinder wahren, um eine unerwünschte Kontaktierung zu vermeiden.

Ein anderer Nachteil des in Fig. 1 bekannten piezo-elektrischen Elements 1 wurde ebenfalls bereits eingangs erwähnt. Flächige bzw. streifenförmige metallische Verbinder wie der Verbinder 4 zeigen bei höheren Temperaturen ein dadurch bedingtes Ausdehnungsverhalten, das sich von dem der keramischen Scheiben 2a - d bemerkenswert unterscheidet. Dieser thermisch bedingte Effekt kann soweit gehen, daß die Verbindungspunkte 5a, b zerstört werden können, wodurch die gesamte Funktion des piezo-elektrischen Elements 1 in Frage gestellt wird.

Vorteilhafter ist ein in der Fig. 2 dargestellter piezo-elektrischer Antrieb bzw. ein Sensorelement 10, das eine erste und bevorzugte Ausführungsform der Erfindung ist. Das zu einem monolithischen Schichtkondensator aufgebaute piezo-elektrische Element 10 umfaßt bei diesem Beispiel vier piezo-keramische Scheiben 12a, 12b. 12c, 12d, in die jeweils Nuten 14a und 14b sowie um etwa 180° versetzt dazu angeordnete Nuten 14c und 14d eingeschnitten sind. Die Nuten 14a-d werden, wie später noch erklärt wird, in die fertig bearbeiteten Keramikscheiben 12a-d eingeschnitten. Die Oberfläche jeder der Keramikscheiben 12a-d, die die Nut 14a-d enthält, wird zusammen mit dieser vollflächig metallisiert, wie es am Beispiel der mit 16a bezeichneten Schicht veranschaulicht wird. Nach dem Zusammenfügen der Keramikscheiben 12a-d in der Fig. 2 abgebildeten Weise und vorzugsweise durch Diffusionsschweißen werden durch die metallisierten Schichten vollflächige Elektrodenschichten 16a, 16b. 16c, 16d gebildet. Durch einen in die Nuten 14a und 14b eingezogenen Draht als Verbinder 18a werden die Elektrodenschichten 16a und 16c leitend miteinander verbunden.

Dabei ist es auf einfache Weise möglich durch geringfügigen Überstand des Verbinders über die Mantelfläche des piezo-elektrischen Elementes 10 hinaus, unerwünschte Kontaktierungen mit anderen Elektrodenschichten zu vermeiden. Ein die Elektrodenschichten 16b und 16d verbindender drahtförmiger Verbinder 18b, der ähnlich dem Verbinder 18a in die Nuten 14c und 14d eingezogen wurde, ist in Fig. 2 angedeutet. An die Verbinder kann auf einfache Weise jeweils eine weitere elektrische Verbindungsleitung zu einer Antriebs- bzw. Meßelektronik angeschlossen werden.

Selbstverständlich ist es für die Erfindung nicht zwingend erforderlich, die Verbinder 18a und 18b im Sinne der in Fig. 2 beispielhaft dargestellten Schlaufen anzuordnen. Es ist genauso gut möglich, die drahtförmigen Verbinder jeweils als einzelne Abschnitte, d.h. im Sinne einzelner Drähte durch die Nuten zu ziehen und erst danach die einzelnen Drähte in der gewünschten Weise miteinander zu verbinden. So kann, falls gewünscht, im Prinzip jede einzelne Elektrode einzeln angesteuert werden. Die drahtförmigen Verbinder 18a und 18b gewährleisten eine dauerhafte Verbindung zu den Elektroden auch bei hohen Temperaturen und ermöglichen eine vollflächige Elektrodenschicht.

Aus Festigkeitsgründen ist es empfehlenswert, die Nuten nicht tiefer in die Keramikschichten einzuschneiden als die Hälfte der durch "S" in Fig. 2 veranschaulichten Stärke der jeweiligen Keramikscheibe. Als besonders vorteilhaft hat sich in der Praxis eine Nuttiefe erwiesen, die etwa dem 0,3-fachen der Stärke der betreffenden Keramikscheibe entspricht.

Vorzugsweise werden Keramikscheiben aus PZT-Material hergestellt. Die Eignung des piezo-elektrischen Elementes 20 nach der Erfindung wird noch verbessert, wenn die Keramikscheiben aus PbMg_{0,308}Nb_{0,617}Ti_{0,075}O₃ bestehen. Eine besondere Hochtemperatureignung erhält man, wenn die piezo-elektrischen Keramikscheiben aus einem Material mit einer Curie-Temperatur größer 400°C bestehen, beispielsweise aus Na_{0,5}Bi_{4,5}Ti₄O₁₅ bzw. Bi₃TiNbO₉.

Die für die Elektrodenschichten und für die drahtförmigen Verbinder verwendeten Materialien sollten in ihren Eigenschaften an diejenigen für die Keramikscheiben verwendeten Materialien angepaßt sein. So empfiehlt es sich für die Elektrodenschichten ein metallischen Material mit einer Curie-Temperatur größer 400°C zu verwenden, vorzugsweise Material aus Wismut-Titanat. Bei den drahtförmigen Verbindern haben sich solche aus einem Material mit einer Hochtemperaturstabilität größer 250°C als besonders vorteilhaft erwiesen, wobei Drähten aus einem silberhaltigen, edelstahlhaltigen Material oder einem solchen, das eine Nickellegierung der Vorzug gegeben werden sollte.

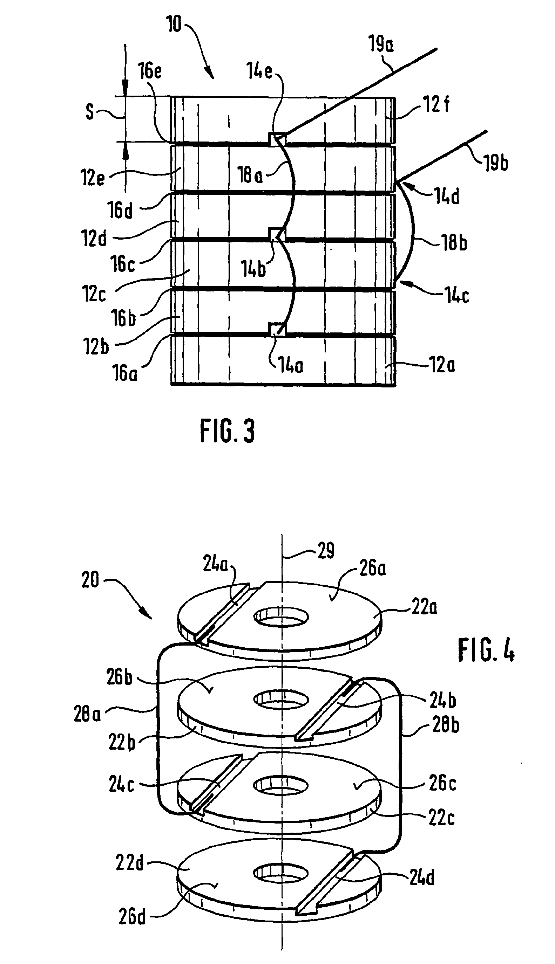

Zur Verdeutlichung der vielfältigen Möglichkeiten und Ausführungen, die sich mit einem piezo-elektrischen Element 10 nach der Erfindung ergeben, ist in Fig. 3 ein gegenüber dem in Fig. 2 quasi "auf dem Kopf stehendes" erweitertes piezo-elektrisches Element 10 mit nunmehr sechs Keramikscheiben 12a, 12b, 12c, 12d, 12e, 12f, fünf Nuten 14a, 14b, 14c, 14d, 14e und dementsprechend fünf Elektrodenschichten 16b, 16c, 16d, 16e, 16f abgebildet. In Fortführung des in Fig. 2 dargestellten Aufbaus verläuft der drahtförmige Verbinder 18a nicht nur in den Nuten 14a, 14b und 14e und verbindet daher die Elektrodenschichten 16a, 16c, 16e zu einer gleichen Polarität, wie es auch der drahtförmige Verbinder 18b mit den Elektrodenschichten 16b und 16d tut. Im übrigen gilt das, was zu dem in Fig. 2 dargestellten piezo-elektrische Element 10 oben gesagt wurde hier in gleicher Weise.

Fig. 4 zeigt eine zweite und bevorzugte Ausführungsform eines piezo-elektrischen Antriebs bzw. Sensorelements nach der Erfindung. Dieses der Einfachheit halber, wie oben, piezo-elektrisches Element 20 genanntes Sensorelement bzw. Antrieb ist so dargestellt, daß in den voneinander beabstandet gezeigten Keramikscheiben 22a, 22b, 22c, 22d der Verlauf dort eingeschnittener Nuten 24a, 24b, 24c, 24d verdeutlicht wird. Im Gegensatz zu den in den Fig. 2 und 3 gezeigten Nuten 14a-e verlaufen die Nuten 24a-d nicht durch die Mitte der Keramikscheiben 22a-d. Die Nuten 24a-d schneiden nicht eine in Fig. 4 dargestellte Längsachse 29 sondern verlaufen im allgemeinen Sinne einer Sekante bezogen die hier beispielhaft dargestellte kreisförmigen Oberflächen der Keramikscheiben 22a-d.

Die Lage der Nuten 24a-d ist zwar an sich beliebig, sie sollten allerdings ähnlich den Nuten 14a-d in der Fig. 2 wiederum von einer Keramikscheibe zur anderen versetzt angeordnet verlaufen, und zwar vorzugsweise derart, daß eine Überlappung von in den Nuten 24a und 24c bzw. 24b und 24d angeordneten Verbindern 28a bzw. 28b ausgeschlossen werden kann. Der Abstand der Nuten 22a-d vom Rand der Keramikscheiben 22a-d ist danach auszurichten, welche Anforderungen an die mechanische Festigkeit der Keramikscheiben 22a-d gestellt werden. Es hat sich gezeigt, daß die Nuten vorzugsweise auf halbem Abstand zwischen der Längsachse 29 und dem Rand der jeweiligen Keramikscheibe angeordnet werden.

Die metallisierten Oberflächen, aus denen durch Zusammenfügen der Keramikscheiben 22a-d die Elektrodenschichten gebildet werden (siehe dazu auch Fig. 2 und Fig. 3) sind in Fig. 4 mit "26a, 26b, 26c, 26d" bezeichnet. Im übrigen gilt das, was bereits zu den in den Fig. 2 und 3 dargestellten Ausführungsformen der Erfindung gesagt wurde.

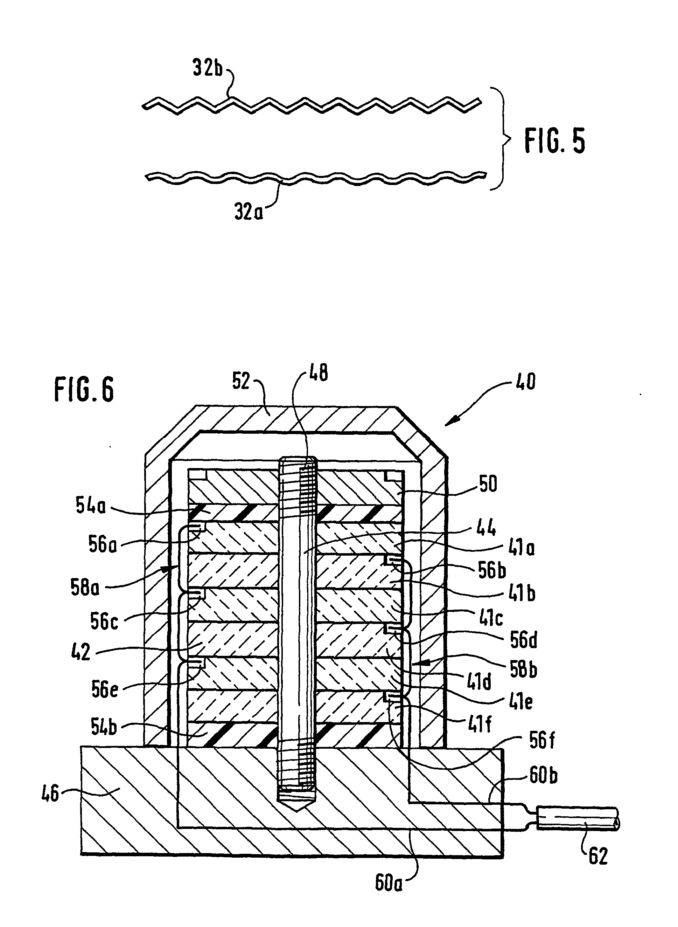

In Fig. 5 sind beispielhaft zwei verschiedene Ausführungen der drahtförmigen Verbinder 18a,b und 28a,b (siehe Fig. 2 bis 4) dargestellt, die sich in der Praxis als besonders vorteilhaft gezeigt haben. , daß ein und ein zackenförmiger Verbinder 32b vorteilhaft sind. Ein in Fig. 5 dargestellter wellenförmiger Verbinder 32a wie auch ein zackenförmiger Verbinder 32b ermöglicht durch seine "Wellenberge" bzw. durch seine Zacken eine sichere elektrische Kontaktierung der Elektrodenschichten, ohne daß bei den oben erwähnten Materialien seine jeweiligen elastischen Eigenschaften verringert werden. Es ist klar, daß die Wellung bzw. Zackung der drahtförmigen Verbinden 32a,b so zu wählen ist, daß ihre Einfädelung in die Nuten 14a-d bzw. 24a-d (siehe Fig. 2 bis 4) nicht behindert wird.

Die in den Fig. 2 bis 4 dargestellten elektromechanischen Antriebe bzw. Sensorelemente nach der Erfindung werden wie folgt hergestellt. Das Verfahren wird am Beispiel des in Fig. 2 dargestellten piezo-elektrischen Elements 10 erläutert. Das Verfahren ist ohne Einschränkung der Erfindung auch für alle anderen möglichen, elektromechanischen Antriebe bzw. Sensorelemente nach der Erfindung anwendbar.

Zunächst werden die keramischen Scheiben 12a-d aus einem oben beschriebenen elektroaktiven Material nach einem in der Keramiktechnologie üblichen Verfahren mit gewünschten Abmessungen hergestellt, wobei eine Reserve von 2-3 mm für jedes Maß unter Berücksichtigung der nachfolgenden mechanischen Bearbeitung vorgesehen ist. Danach werden die keramischen Scheiben 12a-d geschliffen, bis eine vorgegebene Stärke S von beispielsweise 0,15 bis 03 mm erreicht wird. Nach dem Schneiden der gewünschten Nut 14a-d in jede zu metallisierende Oberfläche einer Keramikscheibe 12a-d, wobei die Nut nicht tiefer als die Hälfte der Stärke S der betrachteten Keramikschicht sein darf, werden die betreffende Oberfläche einschließlich der Nut mit einem Metall beschichtet. Dies wird durch wenigstens zweimaliges Aufbringen einer silberhaltigen Paste und nachfolgendem Tempern bei einer Temperatur von 800-820°C erreicht. Anschließend werden die Keramikscheiben in der gewünschten Weise und je nach gewünschter Ausrichtung der Nuten zueinander verbunden, wobei jeweils zwei Keramikschichten durch Verleimen mit Zelluloseleim miteinander verklebt werden. Danach werden die geleimten Keramikscheiben in einem geeigneten Rahmen eingesetzt und durch Diffusionsschweißen bei einer Temperatur von 780-800°C und einachsiger Kompression unter einem Druck von 3-5 kg/cm² im Verlauf von 3 Stunden miteinander zu einer monolithischen Struktur verbacken und dann bis auf Zimmertemperatur abgekühlt. Je ein Verbinder-Draht wird in eine Nut eingezogen, wobei die durch die metallisierten Schichten gebildeten Elektrodenschichten in gewünschter Weise durch Einwirken eines elektrischen Feldes auf die Verbinder-Drähte unter hoher Temperatur polarisiert werden. Anschließend werden die Elektrodenschichten in der gewünschten Weise zusammengeschaltet. Danach werden die gewünschten Parameter und die piezo-elektrischen Eigenschaften des Antriebs bzw. des Sensorelements kontrolliert.

Der Vollständigkeit halber ist in der Fig. 6 ein Beschleunigungssensor 40 dargestellt, der mit einem piezo-elektrischen Sensor nach der Erfindung ausgerüstet ist. Das Sensorelement 42 umfaßt plattenförmige, also eckige keramischen Schichten 41a, 41b, 41c, 41d, 41e, 41f sowie zwischen diesen angeordnete Elektrodenschichten, die zusammen einen bereits oben erwähnten monolithischen Mehrschicht-Kondensator bilden. Das Sensorelement 42 ist mittels eines Befestigungsstabes 44 auf einer Grundplatte 46 befestigt. Zu diesem Zweck haben die einzelnen Keramikplatten 41a-f zentrische Öffnungen ähnlich jenen der Keramikscheiben 22a-d in der Fig. 4, die zusammen einen zentrischen, axialen Durchgang des Sensorelements 42 bilden. Der Befestigungsstab 44 ist fest mit der Grundplatte 46 verbunden, verläuft durch den zentrischen, axialen Durchgang des Sensorelements 42 und erstreckt sich darüber hinaus in einen Abschnitt, der mit einem Gewinde 48 versehen ist. Das Sensorelement 40 ist also über den Befestigungsstab 44 gesteckt und wird mittels einer Haltemutter 50, die auf den Befestigungsstab 44 geschraubt ist, befestigt und mechanisch mit der Grundplatte 46 verbunden. Zur elektrischen Isolierung des Sensorelements 40 gegenüber der Grundplatte 46 und einem ein Gehäuse bildenden Deckel 52 dienen zwei Isolationsschichten 54a, 54b.

Das Sensorelement 40 ist im wesentlichen in ähnlicher Weise aufgebaut, wie die in Fig. 2 bis 4 dargestellten piezo-elektrischen Elemente 10 und 20. Im Gegensatz dazu sind hier jedoch Nuten 56a, 56b, 56c, 56d, 56e, 56f zur Aufnahme von drahtförmigen Verbindern 58a, 58b vorgesehen, welche Nuten an den äußeren Rändern, sozusagen an den Kanten der Keramikplatten 41 a-f verlaufen. Die in gewünschter Weise die Elektroden gleicher Polarität verbindenden drahtförmigen Verbinder 58a,b laufen in elektrische Verbindungsleitungen 60a, 60b aus, die in einem Kabel 62 zusammengefaßt werden, das wiederum mit einer hier nicht dargestellten Meßelektronik verbunden ist.

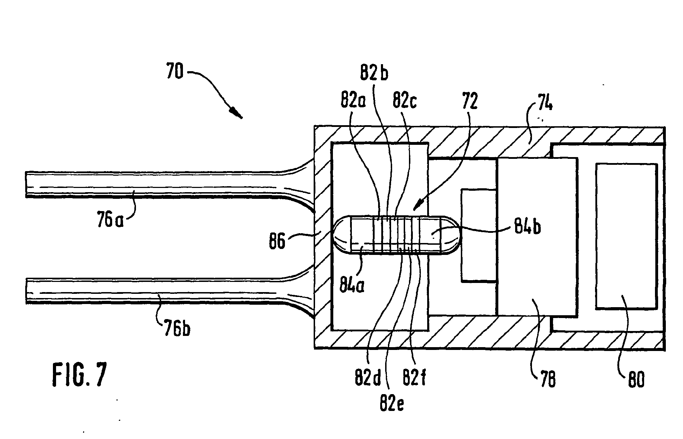

Fig. 7 zeigt beispielhaft eine weiteres Meßgerät, ein Füllstandsmeßgerät, genauer: einen Füllstandsgrenzschalter 70, der mit einem piezo-elektrischen Element 72 ausgerüstet ist, das als monolithischer Block sowohl aus einem Antrieb als auch aus einem Sensorelement nach der Erfindung aufgebaut ist. Der Füllstandsgrenzschalter 70 umfaßt ein Gehäuse 74 und zwei daran befestigte Schwingstäbe 76a, 76b. Die Funktionsweisen solcher Füllstandsgrenzschalter mit Stimmgabel-ähnlichen Schwingstäben sind allgemein bekannt und werden daher hier nicht weiter erläutert.

Das piezo-elektrische Element 72 ist im Innern des Gehäuses 74 mittels eines Befestigungselements 78 befestigt. Das Gehäuse nimmt darüber hinaus aus noch eine hier schematisch dargestellte Antriebs- und Meßelektronik 80 auf.

Das piezo-elektrische Element 72 ist im Prinzip wieder aus piezo-keramischen Scheiben 82a, 82b, 82c, 82d, 82e, 82f sowie hier nicht näher bezeichneten Elektrodenschichten aufgebaut, ähnlich dem piezo-elektrischen Element nach der Figur 3. Der Unterschied hier besteht darin, daß mit Keramikscheiben 82a, 82b und 82c ein Sensorelement gebildet wird und mit den Keramikscheiben 82e und 82f ein Antrieb. Um unerwünschte Spannungseffekte vom Antriebselement auf das Sensorelement zu vermeiden ist dazwischen eine nicht metallisierte eine Keramikscheibe 82d vorgesehen.

Das piezo-elektrische Element 72 weist weiterhin zwei Abschlußelemente 84a, 84b auf, mit denen es einerseits an einem eine Membran 86 bildenden Teil des Gehäuses 74 und andererseits am Befestigungselement 78 anliegt.

### Bezugszeichenliste:

- 1: bisher bekannter Antrieb bzw. Sensorelement
- 2a-d: piezo-keramische Scheibe
- 3a-c: Elektroden
- 4: Verbinder
- 5a,b: Verbindungspunkte
- 10: erste Variante des erfindungsgem. Antriebs bzw. Sensorelements
- 12a-f: piezo-keramische Scheibe
- 14a-d: Nuten
- 16a-e: Elektrodenschicht
- 18a,b: drahtförmiger Verbinder
- 19a,b: Verbindungsleitung zur Meß- bzw. Antriebselektronik
- 20: zweite Variante des erfindungsgem. Antriebs bzw. Sensorelements
- 22a-d: piezo-keramische Scheibe
- 24a-d: Nuten
- 26a-d: Elektrodenschicht
- 28a,b: drahtförmiger Verbinder
- 29: Längsachse von (20)
- 32a: gewellter Draht
- 32b: gezackter Draht
- 40: Beschleunigungssensor
- 41a-f: Keramikplatte
- 42: piezo-elektrisches Sensorelement aus eckigen Platten
- 44: Befestigungsstab
- 46: Grundplatte
- 48: Gewinde auf (44)
- 50: Haltemutter
- 52: Deckel
- 54a,b: Isolationsschicht
- 56a-f: Nuten
- 58a,b: Verbinder
- 60a,b: elektrische Verbindungsleitung
- 62: Kabel
- 70: Füllstandsgrenzschalter
- 72: piezo-elektrisches Element
- 74: Gehäuse
- 76a,b: Schwingstab
- 78: Befestigungselement
- 80: Antriebs- bzw. Auswerte-Elektronik
- 82a-f: keramische Schichten
- 84a,b: Abschlußelement von (76)
- 86: Membran

## Patentansprüche

1. Elektromechanischer Antrieb bzw, Sensorelement in Schichtbauweise, der bzw. das
- mehrere piezo-elektrische Keramikschichten (12a-f; 22a-d; 41 a-f),
- eine zwischen zwei einander zugewandten Oberflächen von direkt benachbarten piezo-elektrischen Keramikschichten angeordnete Elektrodenschicht (16a-e; 26a-d) und
- einen elektrischen Verbinder (18a,b; 28a,b; 58a,b) zur elektrischen Kontaktierung der Elektrodenschicht (18a-e; 26a-d) umfaßt,
-- wobei der Verbinder (18a,b; 28a,b; 58a,b) ebenfalls zwischen den zwei einander zugewandten Oberflächen der piezo-elektrischen Keramikschichten (12a-f; 22a-d; 41a-f) angeordnet und herausgeführt ist,
-- wobei der Verbinder (18a,b; 28a,b; 58a,b) ein sich über die Oberflächen der piezo-elektrischen Keramikschichten (12a-f; 22a-d; 41a-f) hinaus erstreckender Draht ist,
-- und wobei in mindestens einer der zwei einander zugewandten Oberflächen der piezo-elektrischen Keramikschichten (12a-f; 22a-d; 41a-f) eine Nut (14a-d; 24a-d; 56a-f) vorgesehen ist, die den elektrischen Verbinder (18a,b; 28a,b; 58a,b) wenigstens teilweise aufnimmt.

2. Antrieb bzw. Sensorelement nach Ansprüche 1, bei dem die Elektrodenschicht (16a-e; 26a-d) durch Metallbeschichtung metallisierte und mittels Diffusionsschweißen zusammengefügte Oberflächen der piezo-elektrischen Keramikschichten (12a-f; 22a-d; 41a-f) gebildet wird.

3. Antrieb bzw. Sensorelement nach einem der Ansprüche 1 oder 2 mit wenigstens drei piezo-elektrischen Keramikschichten (12a-f; 22a-d; 41a-f) und wenigstens zwei Nuten (14a-d; 24a-d; 56a-f), bei dem diese Nuten (14a-d; 24a-d; 56a-f) zueinander und in Bezug auf eine Längsachse (29) des Antriebs bzw, Sensorelements versetzt angeordnet sind.

4. Antrieb bzw. Sensorelement nach einem der vorgehenden Ansprüche 1, 2 oder 3 mit einem drahtförmigen Verbinder (18a,b; 28a,b; 58a,b), der ein Draht mit einer welligen oder gezackten Struktur ist.

5. Antrieb bzw. Sensorelement nach einem der Ansprüche 1 bis 4 mit piezo-elektrischen Keramikschichten (12a-f; 22a-d; 41a-f) aus PZT-Material.

6. Antrieb bzw. Sensorelement nach einem der Ansprüche 1 bis 5 mit piezo-elektrischen Keramikschichten (12a-f: 22a-d; 41a-f) aus PbMg_{0,308}Nb_{0,617}Ti_{0,075}O₃.

7. Antrieb bzw. Sensorelement nach einem der Ansprüche 1 bis 6 mit piezo-elektrischen Keramikschichten (12a-f; 22a-d; 41a-f) aus einem Material mit einer Curie-Temperatur größer 400°C besteht, beispielsweise aus Na_{0,5}Bi_{4,5}Ti₄O₁₅ bzw. Bi₃TiNbO₉.

8. Antrieb bzw. Sensorelement nach einem der Ansprüche 1 bis 7 mit Elektrodenschichten (16a-e; 26a-d) aus einem metallischen Material mit einer Curie-Temperatur größer 400°C.

9. Antrieb bzw. Sensorelement nach einem der Ansprüche 1 bis 8 mit Elektrodenschichten (16a-e; 26a-d) aus Wismut-Titanat.

10. Antrieb bzw. Sensorelement nach einem der Ansprüche 1 bis 9 mit drahtförmigen Verbindern (18a,b; 28a,b; 58a,b) aus einem metallischen Material mit einer Hochtemperaturstabilität größer 250°C.

11. Antrieb bzw. Sensorelement nach einem der Ansprüche 1 bis 9 mit drahtförmigen Verbindern (18a,b; 28a,b; 58a,b) aus einem silberhaltigen, edelstahlhaltigen Material oder einem solchen, das eine Nickellegierung enthält.

12. Verfahren zur Herstellung elektromechanischer Antrieb bzw. Sensorelement in Schichtbauweise, das folgende Schritte umfaßt:
- Herstellen von keramischer Schichten (12a-f; 22a-d; 41a-f) aus elektroaktiven Material nach einem in der Keramiktechnologie üblichen Verfahren mit gewünschten Abmessungen und mit einer Reserve von 2-3 mm für jedes Maß unter Berücksichtigung der nachfolgenden mechanischen Bearbeitung;
- Schleifen der keramischen Schichten (12a-f; 22a-d; 41a-f) bis eine vorgegebene Stärke von beispielsweise 0,15 bis 03 mm erreicht wird;
- Schneiden einer Nut (14a-d; 24a-d; 56a-f) in eine zu metallisierende Seite der Keramikschichten(12a-f; 22a-d; 41a-f);
- wobei die Tiefe der Nut (14a-d; 24a-d; 56a-f) nicht tiefer als die Hälfte der Stärke der betrachteten Keramikschicht (12a-f; 22a-d; 41a-f) sein darf;
- Metallbeschichten wenigstens dieser Seite der Keramikschichten (12a-f; 22a-d; 41a-f) durch zweimaliges Aufbringen einer silberhaltigen Paste und nachfolgendes Tempern bei einer Temperatur von 800-820°C;
- Leimen der metallisierten Oberflächen von zwei Keramikschichten (12a-f; 22a-d; 41a-f) mit Zelluloseleim;
- Diffusionsschweißen der geleimten Schichten durch Tempern auf eine Temperatur von 780-800°C und einachsiger Kompression unter einem Druck von 3-5 kg/cm² im Verlauf von 3 Stunden und Abkühlung bis auf Zimmertemperatur;
- Einziehen je eines Verbinder-Drahtes (18a,b; 28a,b; 58a,b) in eine Nut (14a-d; 24a-d; 56a-f);
- Polarisation des Antriebs bzw. des Sensorelements durch Einwirkung eines elektrischen Feldes auf die Drähte (18a,b; 28a,b; 58a,b) unter Hochtemperatur;
- Verbinden gleicher Pole des Antriebs bzw. des Sensorelements;
- Kontrolle der gewünschten Parameter und piezo-elektrischen Eigenschaften des Antriebs bzw. des Sensorelements .

13. Füllstandsgrenzschalter (70) mit einem Antrieb bzw. Sensorelement nach einem Ansprüche 1 bis 11 oder der bzw. das nach einem Verfahren nach Anspruch 12 hergestellt wurde.

14. Füllstandsgrenzschalter (70) nach Anspruch 13, bei dem das Sensorelement vom Antrieb durch eine nicht-polarisierte Keramikschicht (82d) getrennt wird.

15. Beschleunigungssensor (40) mit einem Sensorelement nach einem Ansprüche 1 bis 11 oder der bzw. das nach einem Verfahren nach Anspruch 12 hergestellt wurde.

## Claims

1. Electromechanical drive or sensor element with a layer structure, which comprises
- several piezoelectric ceramic layers (12a-f , 22a-d, 41a-f),
- an electrode layer (16a-e, 26a-d) arranged between two surfaces facing each other of directly adjacent piezoelectric ceramic layers, and
- an electrical connector (18a,b, 28a,b, 58a,b) designed to establish an electrical contact with the electrode layer (16a-e, 26a-d),
-- wherein the connector (18a,b, 28a,b, 58a,b) is also arranged between and lead through the two surfaces, which face each other, of the piezoelectric ceramic layers (12a-f , 22a-d, 41a-f),
-- wherein the connector (18a,b, 28a,b, 58a,b) is a wire which extends over and beyond the surfaces of the piezoelectric ceramic layers (12a-f, 22a-d, 41a-f),
-- and wherein a groove (14a-d, 24a-d, 56a-f) is provided in at least one of the two surfaces, which face each other, of the piezoelectric ceramic layers (12a-f , 22a-d, 41 a-f), said groove at least partially accommodating the electrical connector (18a,b, 28a,b, 58a,b).

2. Drive or sensor element as claimed in Claim 1, wherein the electrode layer (16a-e, 26a-d) is formed by surfaces of the piezoelectric ceramic layers (12a-f , 22a-d, 41 a-f) which are metalized by a metal coating and joined by diffusion welding.

3. Drive or sensor element as claimed in one of the Claims 1 or 2 with at least three piezoelectric ceramic layers (12a-f , 22a-d, 41a-f) and at least two grooves (14a-d, 24a-d, 56a-f), said grooves (14a-d, 24a-d, 56a-f) being arranged in an offset pattern in relation to one another and in relation to a longitudinal axis (29) of the drive or sensor element.

4. Drive or sensor element as claimed in one of the previous Claims 1, 2 or 3 with a wire-like connector (18a,b , 28a,b , 58a,b), which is a wire with a rippled or jagged structure.

5. Drive or sensor element as claimed in one of the Claims 1 to 4 with piezoelectric ceramic layers (12a-f, 22a-d, 41 a-f) made of PZT material.

6. Drive or sensor element as claimed in one of the Claims 1 to 5 with piezoelectric ceramic layers (12a-f, 22a-d, 41 a-f) made of PbMg_{0.308}Nb_{0.617}Ti_{0.075}O_{3.}

7. Drive or sensor element as claimed in one of the Claims 1 to 6 with piezoelectric ceramic layers (1 2a-f , 22a-d, 41 a-f) made of a material with a Curie temperature greater than 400 °C, for example Na_{0.5}Bi_{4.5}T₁₄O₁₅ or Bi₃TiNbO₉.

8. Drive or sensor element as claimed in one of the Claims 1 to 7 with electrode layers (16a-e, 26a-d) made from a metal material with a Curie temperature greater than 400 °C.

9. Drive or sensor element as claimed in one of the Claims 1 to 8 with electrode layers (16a-e, 26a-d) made of bismuth titanate.

10. Drive or sensor element as claimed in one of the Claims 1 to 9 with wire-like connectors (18a,b , 28a,b , 58a,b) made of a metal material with a high temperature stability greater than 250 °C.

11. Drive or sensor element as claimed in one of the Claims 1 to 9 with wire-like connectors (18a,b , 28a,b , 58a,b) made from an argentiferous material containing stainless steel, or from a material containing a nickel alloy.

12. Method to produce an electromechanical drive or sensor element with a layer structure, said method comprising the following steps :
- Production of ceramic layers (12a-f , 22a-d, 41a-f) from an electroactive material using a method commonly used in ceramic technology with the desired dimensions and with a reserve of 2-3 mm for each dimension taking subsequent mechanical processing into account:
- Grinding the ceramic layers (12a-f , 22a-d, 41a-f) until a predefined thickness of 0.15 to 0.3 mm, for example, is achieved;
- Cutting a groove (14a-d, 24a-d, 56a-f) in a side of the ceramic layers (12a-f , 22a-d, 41 a-f) to be metal-coated;
-- wherein the depth of the groove (14a-d, 24a-d, 56a-f) should not be deeper than half the thickness of the ceramic layer (12a-f, 22a-d, 41a-f) under consideration;
- Coating at least this side of the ceramic layers (12a-f , 22a-d, 41a-f) with metal by applying an argentiferous paste twice and then tempering at a temperature of between 800 and 820 °C;
- Gluing the metal-coated surfaces of two ceramic layers (12a-f , 22a-d, 41a-f) with a cellulose glue;
- Diffusion-welding of the glued layers by tempering to a temperature of 780-800°C and single-axis compression at a pressure of 3-5 kg/cm² for a period of 3 hours and then cooling to room temperature;
- Introduction of one connector wire (18a,b, 28a,b, 58a,b) into a groove (14a-d, 24a-d, 56a-f), with one wire per groove;
- Polarization of the drive or sensor element by having an electric field act on the wires (18a,b, 28a,b, 58a,b) under a high temperature;
- Connecting identical poles of the drive or sensor element;
- Checking the desired parameters and the piezoelectric properties of the drive or sensor element.

13. Point level switch (70) with a drive or sensor element as claimed in one of the Claims 1 to 11 or which is produced following a process as defined in Claim 12.

14. Point level switch (70) as claimed in Claim 13, wherein the sensor element is separated from the drive by a non-polarized ceramic layer (82d).

15. Acceleration sensor (40) with a sensor element as claimed in one of the Claims 1 to 11 or which is produced following a process as defined in Claim 12.

## Revendications

1. Entraînement électromécanique ou élément capteur doté d'une structure à couches, qui comprend
- plusieurs couches de céramique piézo-électriques (12a-f , 22a-d, 41a-f),
- une couche d'électrode (16a-e, 26a-d) disposée entre deux surfaces faisant face l'une à l'autre de couches de céramique piézo-électriques immédiatement voisines, et
- un élément de liaison électrique (18a,b, 28a,b, 58a,b) destiné à établir un contact électrique avec la couche d'électrode (16a-e, 26a-d),
- l'élément de liaison (18a,b, 28a,b, 58a,b) étant également disposé et sorti entre les deux surfaces faisant face l'une à l'autre de couches de céramique piézo-électriques (12a-f, 22a-d, 41 a-f),
- l'élément de liaison (18a,b, 28a,b, 58a,b) étant un fil s'étendant au-delà des surfaces des couches de céramique piézo-électriques (12a-f , 22a-d, 41a-f),
- et une rainure (14a-d, 24a-d, 56a-f) étant prévue dans au moins l'une des deux surfaces faisant face l'une à l'autre de couches de céramique piézo-électriques, rainure qui recueille au moins partiellement l'élément de liaison électrique (18a,b, 28a,b, 58a,b).

2. Entraînement ou élément capteur selon la revendication 1, pour lequel la couche d'électrode (16a-e, 26a-d) est formée par les surfaces des couches de céramique piézo-électriques (1 2a-f , 22a-d, 41a-f) métallisées par un revêtement métallique et jointes au moyen d'un soudage par diffusion.

3. Entraînement ou élément capteur selon l'une des revendications 1 ou 2 avec au moins trois couches de céramique piézo-électriques (12a-f , 22a-d, 41a-f) et au moins deux rainures (14a-d, 24a-d, 56a-f), pour lequel ces rainures (14a-d, 24a-d, 56a-f) sont disposées de façon décalée l'une par rapport à l'autre et par rapport à l'axe longitudinal (29) de l'entraînement ou de l'élément capteur.

4. Entraînement ou élément capteur selon l'une des revendications précédentes 1, 2 ou 3 avec un élément de liaison en forme de fil (18a,b , 28a,b , 58a,b), qui est un fil doté d'une structure ondulée ou dentelée.

5. Entraînement ou élément capteur selon l'une des revendications 1 à 4 avec des couches de céramique piézo-électriques (12a-f , 22a-d, 41 a-f) en matériau PZT.

6. Entraînement ou élément capteur selon l'une des revendications 1 à 5 avec des couches de céramique piézo-électriques (12a-f, 22a-d, 41a-f) en PbMg_{0,308}Nb_{0,617}Ti_{0,075}O₃.

7. Entraînement ou élément capteur selon l'une des revendications 1 à 6 avec des couches de céramique piézo-électriques (12a-f , 22a-d, 41 a-f) en un matériau avec un point de Curie supérieur à 400 °C, par exemple en Na_{0,5}Bi_{4,5}T₁₄O₁₅ ou Bi₃TiNbO₉.

8. Entraînement ou élément capteur selon l'une des revendications 1 à 7 avec des couches d'électrode (16a-e, 26a-d) en un matériau métallique avec un point de Curie supérieur à 400 °C.

9. Entraînement ou élément capteur selon l'une des revendications 1 à 8 avec des couches d'électrode (16a-e, 26a-d) en titanate de bismuth.

10. Entraînement ou élément capteur selon l'une des revendications 1 à 9 avec des éléments de liaison en forme de fil (18a,b , 28a,b , 58a,b) en un matériau métallique avec une stabilité aux températures élevées supérieures à 250 °C.

11. Entraînement ou élément capteur selon l'une des revendications 1 à 9 avec des éléments de liaison en forme de fil (18a,b , 28a,b , 58a,b) en un matériau argentifère, contenant de l'acier spécial, ou un matériau contenant un alliage de nickel.

12. Procédé destiné à la fabrication d'un entraînement électromécanique ou d'un élément capteur doté d'une structure à couches, qui comprend les étapes suivantes :
- Fabrication de couches de céramique (12a-f, 22a-d, 41a-f) à partir d'un matériau électroactif d'après l'un des procédés usuels en terme de technologie céramique, avec les dimensions souhaitées et avec une réserve de 2 à 3 mm pour chaque dimension, en tenant compte de l'usinage mécanique suivant :
- Meulage des couches de céramique (12a-f , 22a-d, 41a-f) jusqu'à ce qu'une épaisseur prédéfinie de par exemple 0,15 à 0,3 mm soit atteinte ;
- Taillage d'une rainure (14a-d, 24a-d, 56a-f) dans une face à métalliser de la couche de céramique (12a-f, 22a-d, 41a-f) considérée ;
- la profondeur de la rainure (14a-d, 24a-d, 56a-f) ne devant pas être plus profonde que la moitié de l'épaisseur de la couche de céramique (12a-f, 22a-d, 41a-f) considérée ;
- Métallisation d'au moins cette face des couches de céramique (12a-f , 22a-d, 41a-f) par une application double d'un pâte argentifère suivie d'une trempe à une température de 800 à 820 °C ;
- Collage de la surface métallisée de deux couches de céramique (1 2a-f , 22a-d, 41a-f) au moyen d'une colle cellulosique ;
- Soudage par diffusion des couches collées par trempe à une température de 780 à 800 °C et compression uniaxiale sous une pression de 3 à 5 kg/cm² pendant une durée de 3 heures et avec un refroidissement à la température ambiante ;
- Introduction de respectivement un fil de liaison (18a,b, 28a,b, 58a,b) dans une rainure (14a-d, 24a-d, 56a-f) ;
- Polarisation de l'entraînement ou de l'élément capteur par l'action d'un champ électrique sur les fils (18a,b, 28a,b, 58a,b) sous haute température ;
- Raccordement des pôles identiques de l'entraînement ou de l'élément capteur ;
- Contrôle des paramètres souhaités et des propriétés piézo-électriques de l'entraînement ou de l'élément capteur.

13. Détecteur de niveau (70) avec un entraînement ou un élément capteur selon l'une des revendications 1 à 11 ou qui a été fabriqué d'après un procédé selon la revendication 12.

14. Détecteur de niveau (70) selon la revendication 13, pour lequel l'élément capteur est séparé de l'entraînement par une couche de céramique (82d) non polarisée.

15. Capteur d'accélération (40) avec un élément capteur selon l'une des revendications 1 à 11 ou qui a été fabriqué d'après un procédé selon la revendication 12.
